# EUROPÄISCHE PATENTANMELDUNG

(11) **EP 1 170 754 A1**
(43) Veröffentlichungstag der Anmeldung: **09.01.2002**
(21) Anmeldenummer: 01114268.4
(22) Anmeldetag: 12.06.2001
(51) Int. Cl.: G11C 16/20

(54) **Chip-ID-Register-Anordnung**

(30) Priorität: 03.07.2000 DE 10032256
(71) Anmelder: Infineon Technologies AG, 81669 München (DE)
(72) Erfinder: Lammers, Stefan, 81739 München (DE); Manyoki, Zoltan, Kanata, ON K2L 3W9 (CA)
(74) Vertreter: Müller . Hoffmann & Partner Patentanwälte

(57) **Zusammenfassung**

Chip-ID-Register-Anordnung, bei der unter Beanspruchung von wenig Chipfläche ein einheitliches Testen unterschiedlicher Chips ermöglicht ist.

## Beschreibung

Die vorliegende Erfindung betrifft eine Chip-ID(Identifikations)-Register-Anordnung aus einem Schieberegister und einer mit dem Schieberegister verbundenen Fuse-Einrichtung, wobei den einzelnen Stufen des Schieberegisters im Wesentlichen jeweils eine Fuse der Fuse-Einrichtung zugeordnet ist, zur Identifikation eines Chips, indem in der Fuse-Einrichtung Information abspeicherbar ist, die über das Schieberegister zur Identifikation des Chips seriell auslesbar ist.

Damit ein Chip genau identifiziert werden kann, ist in diesem eine Chip-ID-Register-Anordnung ausgeführt. In dieser Chip-ID-Register-Anordnung werden die wesentlichen Daten eines Chips, wie beispielsweise dessen Herstellungsstätte bzw. -fabrik, Losnummer, Design-Version etc. abgespeichert.

Eine derartige Chip-ID-Register-Anordnung besteht aus einem Schieberegister für n Bits und n Fuse-Latches, die jeweils eine Fuse und ein Latchglied aufweisen und im Folgenden auch kurz "Fuses" genannt werden. In diesen Fuses werden Informations-Bits mithilfe beispielsweise eines Lasers programmiert.

Die in den Fuses der Chip-ID-Register-Anordnung gespeicherte Information, also die wesentlichen Daten des Chips, kann bei einem Test des Chips seriell mithilfe eines Takt- bzw. Clock-Signales aus der Register-Anordnung ausgelesen werden.

Nun ist zu beachten, dass für unterschiedliche Chips auch unterschiedliche Information von Bedeutung ist. So gibt es Information, die in jedem Chip gespeichert werden muss, wie beispielsweise dessen Seriennummer oder Wafer-Nummer. Andere Information braucht nur auf einigen Chips abgespeichert zu werden, wie beispielsweise die so genannte "Splitlos-Information".

In der folgenden Tabelle ist ein möglicher Aufbau einer Chip-ID-Register-Anordnung veranschaulicht. Diese Register-Anordnung umfasst insgesamt 74 speicherbare Bits, die in dreizehn Kategorien ("Feldname" bzw. "field name") A bis M unterteilt sind, denen jeweils eine wesentliche Information ("Feldbeschreibung" bzw. "field description") zugeordnet ist, wie beispielsweise Los-Nummer ("lot number"), Wafer-Nummer ("wafer number"), X-Koordinate, Y-Koordinate etc. Jede Kategorie A bis M verfügt über eine bestimmte Anzahl von Bits ("number of bits required"). Inhalte, beispielsweise Zahlen 0 bis 9, und diesen zugeordnete Bedeutungen bzw. "Kommentare" ("comment"), wie beispielsweise ein Herstellungsjahr, sind in weiteren Spalten abgelegt.

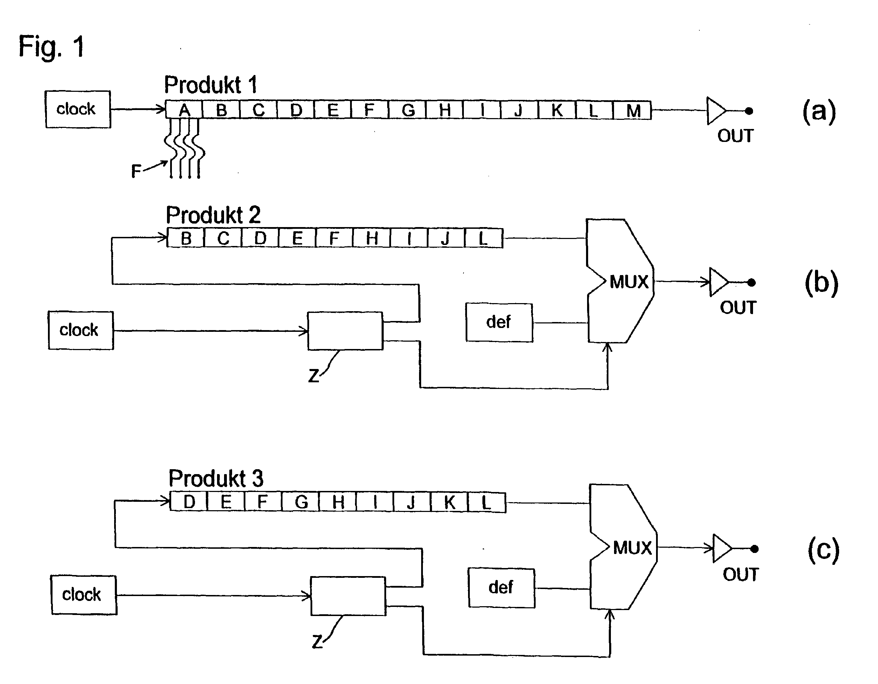

Mit den Kategorien A bis M sollen in den Figuren jeweils eine Schieberegister-Stufe und daran angeschlossene Fuses F veranschaulicht sein, wie dies schematisch für die Kategorie A in Fig. 1 gezeigt ist.

| field name | field description | number of bits required | contents | comment | product | | |
|---|---|---|---|---|---|---|---|
| | | | | | 1 | 2 | 3 |
| A | fab & encode level | 4 | | | A | | |
| B | | 5 | A ... Z, 3 | 1^{st} char (fab) | B | B | |
| C | | 5 | A ... Z | classification | C | C | |
| D | | 4 | 0 ... 9 | year | D | D | D |
| E | lot number | 6 | 1 ... 53 | week | E | E | E |
| F | | 10 | 0 ... 999 | serial number | F | F | F |
| G | | 7 | 00 ... 99 | split lot info | G | | G |
| H | wafer number | 6 | 1 ... 50 | | H | H | H |
| I | X coordinate | 6 | 0 ... 63 | | I | I | I |
| J | Y coordinate | 6 | 0 ... 63 | | J | J | J |
| K | prefuse sort | 5 | | | K | | K |
| L | design version | 4 | | | L | L | L |
| M | product code | 6 | | | M | | |
| | | | | total bits: | 74 | 52 | 54 |

Ein erster Chip ("Produkt 1" bzw. "product 1") kann beispielsweise alle Kategorien A bis M verwenden, während ein zweiter Chip ("Produkt 2") und ein dritter Chip ("Produkt 3") nur einige Teile der Chip-ID-Register-Anordnung benötigen.

Zur Vereinfachung des Auslesevorganges wird für jede Chipart, also jedes Produkt, ein einheitliches Test-Interface zur Verfügung gestellt, sodass die verschiedenen Chip-ID-Register-Anordnungen der unterschiedlichen Chips alle mit dem gleichen Test ausgelesen werden können. Dadurch wird ohne Weiteres Testzeit eingespart. Allerdings ist ein Nachteil darin zu sehen, dass die einzelnen Chip-ID-Register-Anordnungen auf den verschiedenen Chips mehr Chipfläche beanspruchen, als dies eigentlich nötig wäre: Für Produkt 2 und Produkt 3 ist so die gleiche Chipfläche wie für Produkt 1 erforderlich, obwohl Produkt 2 insgesamt nur 52 Bits und Produkt 3 nur 54 Bits anstelle der 74 Bits von Produkt 1 in ihren jeweiligen Chip-ID-Register-Anordnungen abspeichern müssen.

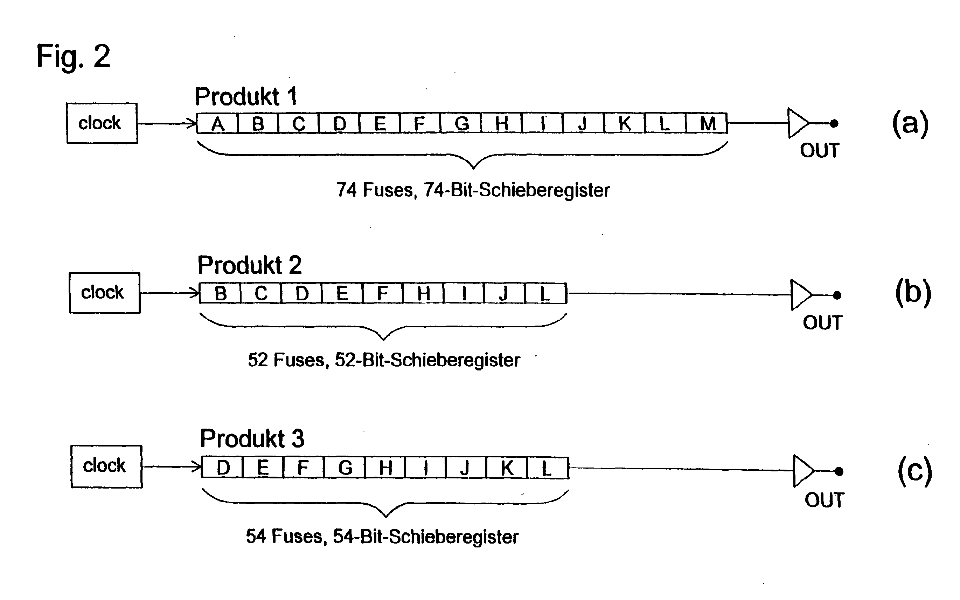

Fig. 2 zeigt schematisch, wie bei einer Chip-ID-Register-Anordnung Chipfläche eingespart werden kann, wobei hier als Beispiele das Produkt 1 (Fig. 2(a)), das Produkt 2 (Fig. 2(b)) und das Produkt 3 (Fig. 2(c)) angegeben sind. Hier ist auf jedem Chip eine individuelle Chip-ID-Register-Anordnung ausgeführt, in welcher nur die für den jeweiligen Chip ("Produkt") erforderliche Information abgespeichert ist. Das Produkt 1 benötigt 74 Bits und hat eine entsprechend große Chip-ID-Register-Anordnung mit einem 74-Bit-Schieberegister, bei dem jeder Kategorie A bis M die jeweils entsprechende Anzahl von Fuses zugeordnet ist. So hat beispielsweise die Kategorie A vier Fuses, die Kategorie B fünf Fuses, die Kategorie C fünf Fuses etc. (vgl. Tabelle 1).

Die Produkte 2 und 3 kommen im Vergleich zu Produkt 1 mit einer wesentlich kleineren Chip-ID-Register-Anordnung aus und weisen jeweils ein 52-Bit-Schieberegister (Produkt 2) und ein 54-Bit-Schieberegister (Produkt 3) auf.

Beim Auslesen der herkömmlichen Chip-ID-Register-Anordnung des Beispiels der Fig. 2 wird in das Schieberegister ein Taktsignal "clock" eingegeben, das in den einzelnen Schieberegistern für die Produkte 1 bis 3 jeweils den in den Fuses abgespeicherten Informationsinhalt ausliest. Dabei muss jeder Chip bzw. jeder Chiptyp individuell getestet werden, da die einzelnen Schieberegister in ihren Stufen Informationen von unterschiedlichen Kategorien enthalten: So enthält das Produkt 1 in der ersten Stufe Information der Kategorie A, während die Produkte 2 und 3 in ihren ersten Stufen jeweils Informationen der Kategorien B bzw. D aufweisen. Dies bedeutet, dass unterschiedliche Test-Interfaces für die verschiedenen Produkte benutzt werden müssen, damit die Register der verschiedenen Chip-ID-Register-Anordnungen richtig ausgelesen werden können. Mit anderen Worten, das Produkt 1 benötigt ein Test-Interface, das darauf abgestellt ist, dass in dem Register alle Kategorien A bis M abgespeichert sind, während für das Produkt 2 und für das Produkt 3 Test-Interfaces benötigt werden, die jeweils davon ausgehen, dass in den Registern dieser Produkte Informationen der angegebenen Kategorien abgelegt sind. Die Chip-Identifikation wird an einem Ausgang OUT erhalten.

Mit einer auf dem anhand von Fig. 2 erläuterten Prinzip beruhenden Chip-ID-Register-Anordnung kann so Chipfläche eingespart werden. Diese Chip-ID-Register-Anordnung weist aber den erheblichen Nachteil auf, dass die Benutzung eines einheitlichen Test-Interfaces ausgeschlossen ist und für jede verschiedene Art von Chips unterschiedliche Test-Interfaces benötigt werden.

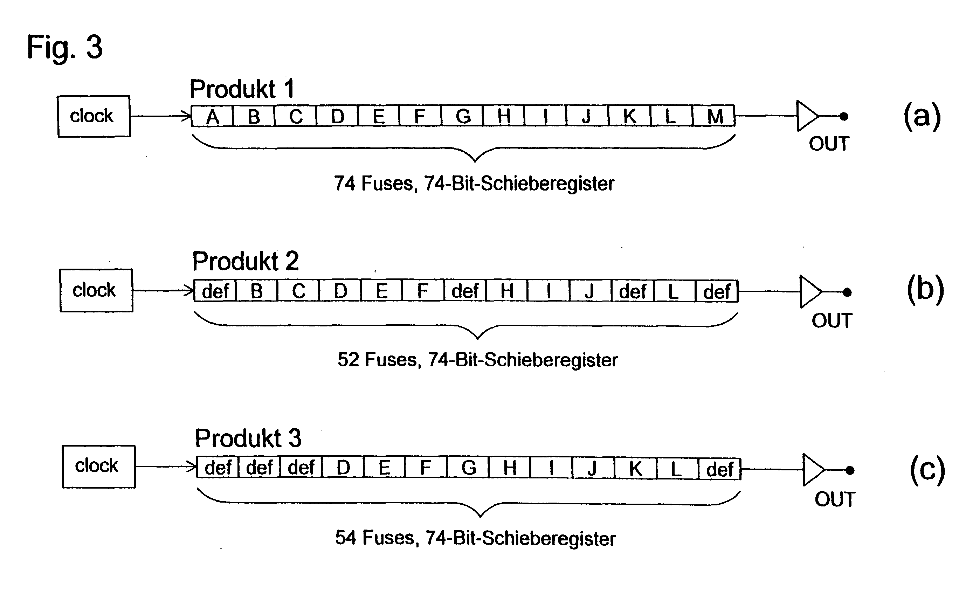

In Fig. 3 ist eine Chip-ID-Register-Anordnung schematisch dargestellt, die die Benutzung eines einheitlichen Test-Interfaces erlaubt. Dabei sind wieder in Fig. 3(a) eine Chip-ID-Register-Anordnung für das Produkt 1, in Fig. 3(b) eine Chip-ID-Register-Anordnung für das Produkt 2 und in Fig. 3(c) eine Chip-ID-Register-Anordnung für das Produkt 3 von obiger Tabelle 1 schematisch gezeigt.

Bei dem Beispiel von Fig. 3 wird auf jedem Chip eine einheitliche Chip-ID-Register-Anordnung für 74 Bits ausgeführt, wobei sich die Anzahl der tatsächlich integrierten Fuses nach dem Produkt richtet. D. h., das Produkt 1 besitzt 74 Fuses, während das Produkt 2 und das Produkt 3 jeweils 52 Fuses bzw. 54 Fuses aufweisen.

Bei dem Produkt 1 sind allen Stufen des Schieberegisters von der Kategorie A bis zu Kategorie M jeweils Fuses zugeordnet, sodass hier insgesamt 74 Fuses vorliegen. Das Produkt 2 hat dagegen Fuses lediglich in den Stufen des Schieberegisters, die benötigten Kategorien entsprechen, also in den Stufen B, C, D etc., während in den Stufen des Schieberegisters mit nicht benötigten Kategorien, also beispielsweise in den Stufen der Kategorie A, nur eine definierte Information beinhaltet ist, beispielsweise "0000", was in Fig. 3 mit "def" angegeben ist.

Bei der Chip-ID-Register-Anordnung von Fig. 3 wird also in die einzelnen Chips der verschiedenen Chiptypen immer ein gleichgroßes Schieberegister integriert, obwohl auch ein kleineres Schieberegister, wie bei den Produkten 2 und 3, ausreichend wäre. Mit anderen Worten, es wird hier mehr Chipfläche beansprucht als tatsächlich benötigt wird.

Dafür ist die Benutzung eines einheitlichen Test-Interfaces möglich, da bei nicht benötigten Kategorien, also beispielsweise bei der Kategorie A des Produktes 2, am Ausgang OUT der Chip-ID-Register-Anordnung die definierte Information ("def") gewonnen wird, wenn die Schieberegisterstufen der Kategorie A ausgelesen werden.

Es ist nun Aufgabe der vorliegenden Erfindung, eine Chip-ID-Register-Anordnung zu schaffen, die es erlaubt, unter Einsparung von Chipfläche im Auslesen einheitliche Test-Interfaces zu verwenden.

Diese Aufgabe wird bei einer Chip-ID-Register-Anordnung erfindungsgemäß durch eine Logikschaltung gelöst, die abhängig von der Art des zu identifizierenden Chips die Fuse-Einrichtung oder eine definierte Information ausliest.

Die erfindungsgemäße Chip-ID-Register-Anordnung vereinigt so die Vorteile der oben anhand der Fig. 2 und 3 erläuterten bestehenden Register-Anordnungen: Trotz Verwendung von einheitlichen Test-Interfaces ist es möglich, bei den einzelnen Chiptypen die für die Chip-ID-Register-Anordnung benötigte Chipfläche an den tatsächlichen Bedarf anzupassen. Hierzu werden in der erfindungsgemäßen Chip-ID-Register-Anordnung die für den jeweiligen Chiptyp bzw. das jeweilige Produkt wichtigen Informationen abgespeichert. In dieser Chip-ID-Register-Anordnung wird jede Fuse und jede Registerstufe des Schieberegisters benutzt. Damit nun die Chip-ID-Register-Anordnungen verschiedener Chiptypen bzw. Produkte auf die gleiche Weise ausgelesen werden können, ist zusätzlich die Logikschaltung aus einem Zähler und einem Multiplexer in den jeweiligen Chips integriert. Diese Logikschaltung sorgt dafür, dass für eine nicht benötigte Kategorie eine definierte Information ausgelesen wird. Der Multiplexer liefert dazu dem Ausgang entweder den Inhalt des Schieberegisters oder die definierte Information. Ein Zähler, der von dem Takt- bzw. clock-Signal gesteuert ist, gibt die Signale zum Auslesen des Schieberegisters und zum Steuern des Multiplexers ab. Dieser Zähler ist für jeden Chiptyp bzw. jedes Produkt speziell entwickelt, was allerdings keinen hohen Aufwand erfordert.

Zusammenfassend beansprucht die erfindungsgemäße Chip-ID-Register-Anordnung weniger Chipfläche als bestehende Register-Anordnungen und erlaubt dennoch ein einheitliches Testen von unterschiedlichen Chiptypen bzw. Produkten mit einem Test-Interface.

Nachfolgend wird die Erfindung anhand der Zeichnungen näher erläutert. Es zeigen:
- Fig. 1(a), (b) und (c): ein Ausführungsbeispiel der erfindungsgemäßen Chip-ID-Register-Anordnung,
- Fig. 2(a), (b) und (c): ein Beispiel einer bestehenden ChipID-Register-Anordnung mit verringerter Chipfläche, jedoch uneinheitlichen Test-Interfaces und
- Fig. 3(a), (b) und (c): ein Beispiel einer bestehenden ChipID-Register-Anordnung mit einheitlichen Test-Interfaces, jedoch vergrößerter benötigter Chipfläche.

Die Fig. 2(a), (b) und (c) sowie die Fig. 3(a), (b) und (c) sind bereits eingangs erläutert worden.

In den Figuren werden füreinander entsprechende Bauteile jeweils die gleichen Bezugszeichen verwendet.

Fig. 1 zeigt schematisch die erfindungsgemäße Chip-ID-Register-Anordnung für das Produkt 1 (Fig. 1(a)), das Produkt 2 (Fig. 1(b)) und das Produkt 3 (Fig. 1(c)) der Tabelle 1.

Fig. 1(a) entspricht dabei Fig. 2(a) bzw. Fig. 3(a). Mit anderen Worten, hier liegt ein Chip vor, der Information von allen Kategorien A bis M benötigt. D. h., ein dieser Information entsprechendes Taktsignal "clock" wird in das Schieberegister eingespeist, bei dem alle Stufen mit entsprechenden Fuses F (genauer: Fuses-Latches) versehen sind. Am Ausgang OUT wird sodann die entsprechende ID-Information von allen Stufen des Schieberegisters erhalten.

Bei einem Chip entsprechend dem Produkt 2, bei dem zur Identifikation 52 Bits benötigt werden, hat die erfindungsgemäße Chip-ID-Register-Anordnung eine Logikschaltung aus einem Zähler Z und einem Multiplexer MUX, an dessen einem Eingang ein Schieberegister mit Registerstufen entsprechend Bits der Kategorien B, C, D, E, F, H, I, J und L und an dessen anderem Eingang eine definierte Information "def", die in einer entsprechenden Speichereinheit abgespeichert sein kann und beispielsweise "0000" beträgt, liegen. Das Taktsignal "clock" ist dem Zähler Z zugeführt. Der Zähler Z zählt die Takte und liefert bei Zählerständen, die beispielsweise der Kategorie A entsprechen, ein Signal an den Multiplexer MUX, so dass dieser die definierte Information "def" abruft und zum Ausgang OUT gibt. Gleiches gilt für die Zählerstände entsprechend den Kategorien G, K und M. Dagegen wird bei Zählerständen entsprechend den Kategorien B, C, D, E, F, H, I, J die Information aus den Fuses über das Schieberegister ausgelesen. Der Multiplexer MUX gibt dann an den Ausgang OUT den Inhalt der jeweiligen Stufe des Schieberegisters entsprechend diesen Kategoerien B, C, D, E, F, H, I, J weiter.

Auf diese Weise benötigt die Chip-ID-Register-Anordnung des Ausführungsbeispiels gemäß Fig. 1(b) weniger Chipfläche, da Fuses für Informationsbits der Kategorien A, G, K und M eingespart werden können. Dennoch ist ein einheitliches Test-Interface verwendbar, da dem Ausgang OUT Information entsprechend allen Kategorien A bis M zugeführt ist. Durch die Verbindung zwischen dem Zähler Z und dem Schieberegister wird dabei sichergestellt, dass das Schieberegister Information der jeweils zutreffenden Stufe zu dem Multiplexer MUX abgibt.

Der zusätzliche Aufwand für die Logikschaltung aus dem Zähler Z und dem Multiplexer MUX ist gegenüber der eingesparten Chipfläche für nicht benötigte Registerstufen gering, sodass die Erfindung erhebliche Vorteile mit sich bringt.

Fig. 1(c) zeigt schließlich noch ein Ausführungsbeispiel mit einem Schieberegister entsprechend dem Produkt 3 der eingangs angeführten Tabelle. Im Übrigen entspricht dieses Ausführungsbeispiel dem Ausführungsbeispiel von Fig. 1(b), wobei hier ein 54-Bit-Schieberegister anstelle des 52-Bit-Schieberegisters von Fig. 1(b) vorgesehen ist.

## Patentansprüche

1. Chip-ID-Register-Anordnung aus einem Schieberegister und einer mit dem Schieberegister verbundenen Fuse-Einrichtung (F), wobei den einzelnen Stufen des Schieberegisters im Wesentlichen jeweils eine Fuse der Fuse-Einrichtung (F) zugeordnet ist, zur Identifikation eines Chips, indem in der Fuse-Einrichtung (F) Information verschiedener Kategorien (A bis M) abspeicherbar ist, die über das Schieberegister zur Identifikation des Chips seriell auslesbar ist, **gekennzeichnet durch**
eine Logikschaltung (Z, MUX), die abhängig von den Kategorien (A bis M) des zu identifizierenden Chips bei benötigter Kategorie die Fuse-Einrichtung (F) und bei nicht benötigter Kategorie eine in einer Speichereinheit (def) gespeicherte definierte Information ausliest.

2. Chip-ID-Register-Anordnung nach Anspruch 1,
**dadurch gekennzeichnet, dass**
die Logikschaltung (Z, MUX) aus einem Zähler (Z) und einem Multiplexer (MUX) besteht.

3. Chip-ID-Register-Anordnung nach Anspruch 2,
**dadurch gekennzeichnet, dass**
der Zähler (Z) an seinem Eingang mit einem Taktsignal (clock) beaufschlagt und an seinem Ausgang einerseits mit dem Multiplexer (MUX) und andererseits mit dem Schieberegister verbunden ist.

4. Chip-ID-Register-Anordnung nach Anspruch 3,
**dadurch gekennzeichnet, dass**
der Multiplexer (MUX) an seinem einen Eingang mit der definierten Information beaufschlagt und an seinem anderen Eingang mit dem Ausgang des Schieberegisters verbunden ist.
